# EUROPEAN PATENT SPECIFICATION

(11) **EP 1 069 436 B1**
(45) Date of publication and mention of the grant of the patent: **09.06.2004**
(21) Application number: 99203602.0
(22) Date of filing: 27.10.1999
(51) Int. Cl.: G01R 15/16

(54) **Directional high voltage detector**
Direktioneller Hochspannungsdetektor
Détecteur de haute tension directionnel

(30) Priority: 12.07.1999 DK 991010
(43) Date of publication of application: 17.01.2001
(73) Proprietor: Jomitek ApS, 2840 Holte (DK)
(72) Inventor: Johansen, Oluf Peter Kaad, 2840 Holte (DK)
(74) Representative: Elmeros, Claus

(56) References cited:
- EP-A- 0 071 560
- EP-A- 0 809 115
- CN-A- 1 195 775
- DE-A- 3 145 255
- US-A- 5 438 256

## Description

### Field of the invention

The invention relates to a directional high voltage detector according to the preamble of claim 1 and method of detecting the direction of an energy flow in a high voltage conductor. A corresponding method according to claim 14 is also provided.

### Background of the invention

A high voltage distribution or transmission system normally comprises numerous conductors directly or indirectly connecting a number of electrical energy generators and electrical energy consumers. The conductors in the distribution system can be in the form of overhead power lines and underground power cables or combinations of both. The electrical energy generators will normally be power plants such as nuclear, water or coal burning electrical power plants but also wind turbine plants and similar kinds of plants are possible.

The energy consumers may be all kinds of electrical energy users in society such as electrical machinery in factories, electrical light in offices and electrical heating apparatus in private houses etc. Other kinds of electrical energy users are hospitals where e.g. life support machines are driven by electrical energy and airports where traffic system computers also are driven by electrical energy.

The dependency of a society on a reliable electrical power supply and especially a reliable distribution or transmission system is indisputable and even shorter interruptions of the supply can have a significant economically effects on the society and also result in loss of human lives.

The transmission and distribution system is especially vulnerable to different kind of faults because of its size. In order to detect and locate faults in a fast and reliable way, it is necessary to be able to survey the system continuously.

Previously, surveillance has been performed by detectors shattered along the transmission and distribution system, with communication links to a surveillance centre. The detectors normally read the voltage or current in the system on the basis of different kinds of measuring methods such as inductive or capacitive methods. Combinations of inductive and capacitive detectors measuring both voltage and current are also known.

The detectors report if they detect significant changes in voltage or current indicating that a fault has occurred in the transmission and distribution system. A large problem is, however, the fact that they lack the capability of indicating where the fault has occurred.

At the same time, the known detectors are voluminous and heavy in addition to being quite expensive. Especially the detectors using measuring methods including transformers or Rukowski coils will suffer from these drawbacks.

Chinese patent application CN-A 1 195 775 disclose a method for recognizing a fault direction in a transmission line by integration of voltage and current values. At the end of the fault, the integrated sum of multiplied voltage and current values equals the amount of fault energy and the positive or negative value of the fault energy will indicate the fault direction in the transmission line.

### Summary of the invention

When a directional high voltage detector for a high voltage conductor comprising at least one voltage measuring circuit for measuring voltage in said conductor, at least one current measuring circuit for measuring current in said conductor and means for deriving the energy flow in the conductor on the basis of measurements by said voltage measuring circuit and said current measuring circuit, it is possible not only to detect a fault in the conductor but also to indicate in which direction it has occurred from the detector.

This is an important advance over the prior art because it makes it possible to locate a fault in the conductor faster and thereby restore the transmission and distribution system in its normal functional way sooner.

When the voltage measuring circuit comprises at least one capacitive detector which forms a capacitive coupling with the conductor, it is possible to measure the high voltage without creating physical connection between the conductor and the measuring circuit. This is very important due to the high voltage being measured.

When the capacitive detector comprises a plate covering a section of the conductor partially or totally, it is possible to create a capacitive coupling which easy to design and adapt to different kinds of conductors or voltage values. The size of the plate can easily be changed as well as the distance between the plate and the conductor.

When the edges or corners of the plate are bent away from the conductor, it is possible to raise the breakdown voltage for the capacitive detector by increasing the distance from the plate to the conductor at the most likely places of a breakdown.

When the dielectric material between the plate and the conductor is silicone, which covers the surface of said detector partially or totally, it is possible to create a capacitor with an accurately defined dielectric constant.

When the silicone layer serves as an isolation layer between the high voltage potentials in said detector and the exterior, it is possible to protect e.g. human beings from the danger of life-threatening electric shock.

The silicone also protects the circuits of the detector from humidity and aggressive gasses.

When at least one capacitor is connected in a series connection to the capacitive coupling and a reference potential respectively, it is possible to create a purely capacitive voltage divider.

Thereby, the output voltage from the divider will be without phase displacement which makes it unnecessary to make any adjustments to the measured voltage or current values in the calculation while also making it possible to detect very low voltage levels.

The measured value will moreover be a real-time image of the conductor voltage value and polarity.

When the reference potential is the ground-symmetrical potential of at least one conductor it is possible to measure the current proportionately to a fixed reference, ensuring a high degree of accuracy of measurement.

When the current measuring circuit comprises at least one detector for measuring of the magnetic field generated by the current in the conductor, it is possible to measure current without any physical connection between the conductor and the measuring circuit.

The measured value will also be a real-time image of the value and polarity of the current in the conductor.

When the magnetic field detector comprises two hall elements, it is possible to cancel out an interference field by adding the two detected values for the interference field. The first hall element will detect the interference field in one direction and the second hall element will detect the interference field in the opposite direction.

Hereby it is possible to e.g. cancel out a magnetic field from a conductor which is placed in proximity to a conductor equipped with a directional high voltage detector which should not affect the actual reading of the detector.

When the supply lines for the magnetic field detectors and the calculation circuit comprise shields against magnetic fields, it is possible to avoid reading errors. The measured voltage is only a few millivolts and occurs in a very powerful electromagnetic field only a few milimeters from the high voltage in the conductor. This may easily result in reading errors as the slightest and seemingly insignificant capacitive coupling between the various components/supply lines and the conductor results in reading errors of the current as a result of the capacitive coupling from the conductor voltage. Furthermore, the electromagnetic fields from other conductors may also create reading errors.

When a directional high voltage detector for a high voltage conductor comprising at least one voltage measuring circuit for measuring a voltage in said conductor by means of at least one capacitive detector, at least one current measuring circuit for measuring current in said conductor by means of at least one magnetic field detector and means for deriving the energy flow in the conductor on basis of measurement by said voltage measuring circuit and said current measuring circuit, it is possible to detect the energy flow in the conductor in an advantageous manner.

When said means derives the energy flow direction on the basis of the polarity of the current and voltage between two preceding zero crossings of the voltage, it is possible to detect the direction of the energy flow in a fast and reliable way. Especially because of the measured voltage and current values being real-time images of the conductor voltage and current in value and polarity.

When an apparatus for measuring on a high voltage conductor comprising at least one voltage measuring circuit for measuring a voltage in said conductor by means of at least one capacitive detector, at least one current measuring circuit for measuring a current in said conductor by means of a magnetic field detector and means for deriving the energy flow in the conductor on basis of measurement by said voltage measuring circuit and said current measuring circuit, it is possible to indicate the direction of an energy flow in a high voltage conductor.

When an apparatus for measuring on a conductor comprising at least one voltage measuring circuit for measuring voltage in said conductor by means of at least one capacitive detector, at least one current measuring circuit for measuring a current in said conductor by means of at least one magnetic field detector and means for deriving the energy flow in the conductor on basis of measurement by said voltage measuring circuit and said current measuring circuit, it is possible to indicate the direction of an energy flow in a conductor.

When the magnetic field detector comprises at least one magnetic-resistive (magneto-resistive) detector it is possible to measure small current intensity in an advantageous manner.

When, as stated in claim 17, a high voltage fault detector for a high voltage conductor wherein the said detector comprises means to determine the direction of the energy flow in said conductor, it is possible not only to detect a fault in the high voltage conductor but also to indicate in which direction it is seen from the detector.

### Drawings

The invention will be described below with reference to the drawings in which
- fig. 1: illustrates a transmission and distribution system equipped with a directional high voltage detector according to the invention,
- fig. 1a: illustrates a part of a transmission and a distribution system in details,
- fig. 2: illustrates the basic elements in a directional high voltage detector,
- fig. 3: illustrates a preferred embodiment of a directional high voltage detector according to the invention,

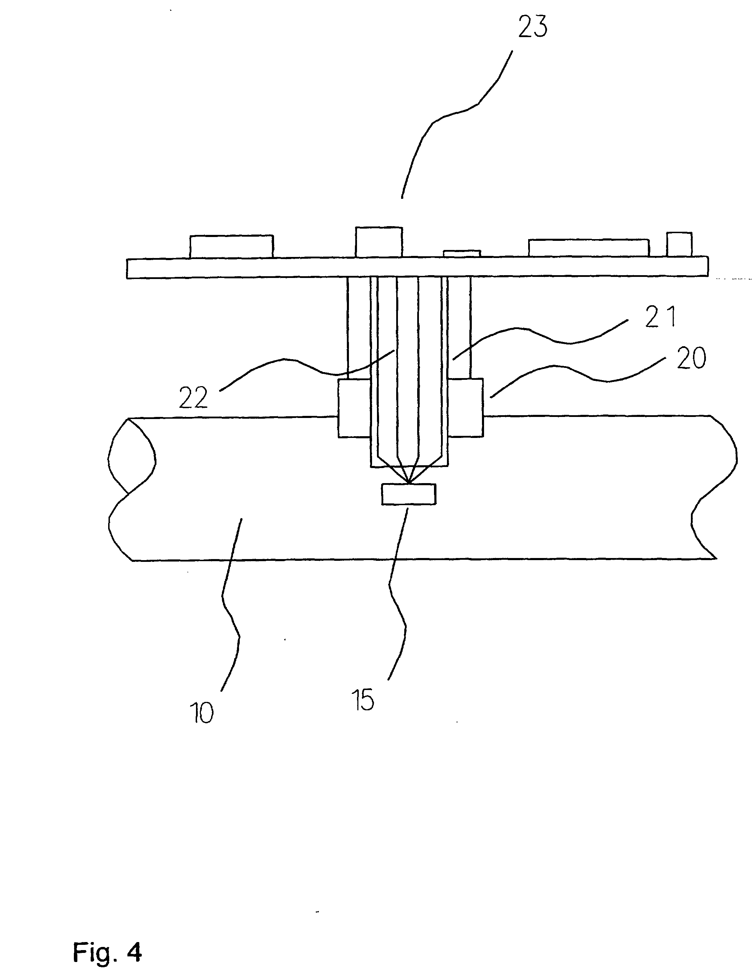

- fig. 4: illustrates the preferred embodiment of a directional high voltage detector seen from another angle,
- fig. 5: illustrates a representation of voltage and current values,
- fig. 6: illustrates a fraction of the representation centred around a zero crossing for the voltage.

### Detailed description

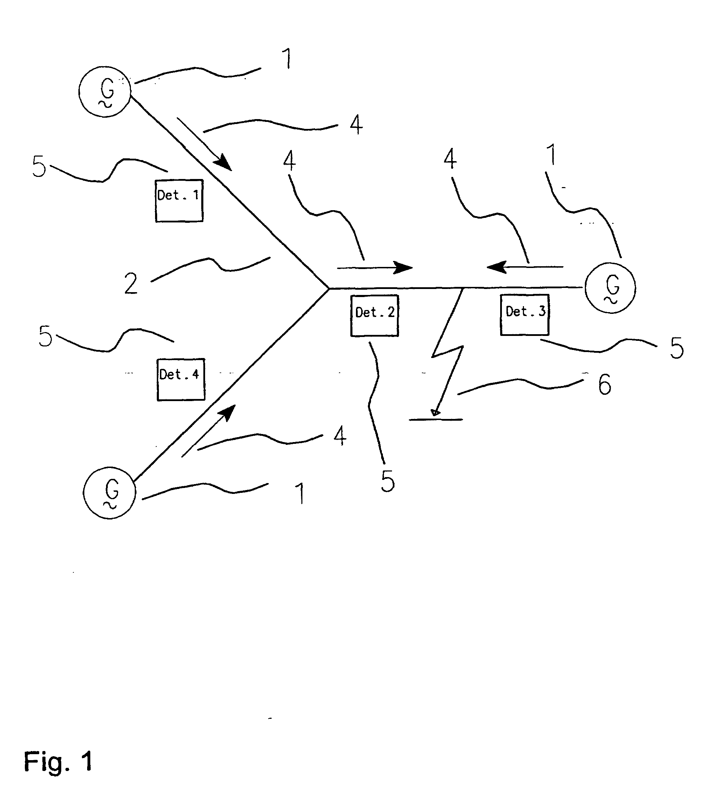

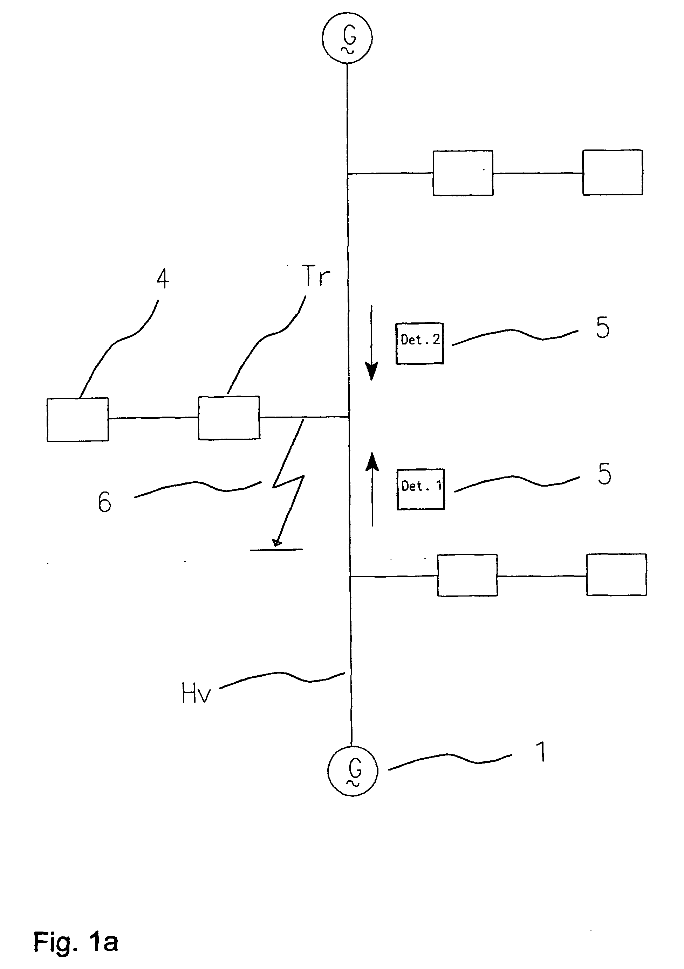

Referring to fig. 1, a transmission and distribution system 2 consisting of overhead power lines or underground power cables, connecting one or more energy producers 1 with the energy users or loads enabling a transfer of electrical energy. The transfer of electrical energy will normally be at a high voltage, and especially AC voltage, to ensure a minimum of energy loss during the transport through the transmission and distribution system. Also the voltage will normally be a 3-phased voltage meaning that the power lines or cables consist of at least 3 conductors.

The lines or cables of the transmission and distribution system are of considerable length which makes it vulnerable to faults of different kind. A short circuit 6 in the system may e.g. occur as a result of animal attacks, landslides and construction machinery working in wrong places. Deterioration of the cable isolation can be another reason to a short circuit. In order to determine the location of the fault a number of directional detectors 5 are placed along the conductors of the transmission and distribution system. The detectors will on basis of voltage and current measurements determine the direction of the energy flow in the conductor. When a fault occurs, the directional detectors will point toward the location of the fault toward which the energy is flowing.

Referring to fig. 1a, a possible fault situation in a transmission and distribution system is illustrated. The transmission and distribution system includes a high voltage cable or line Hv and a number of high voltage transformers Tr which on the low voltage side each are connected to one or more loads 4. In this fault situation a short circuit 6 has occurred on the high voltage side of a transformer Tr. The detectors 5 placed along the high voltage cable or line all points toward the location of the short circuit being to were the energy is floating.

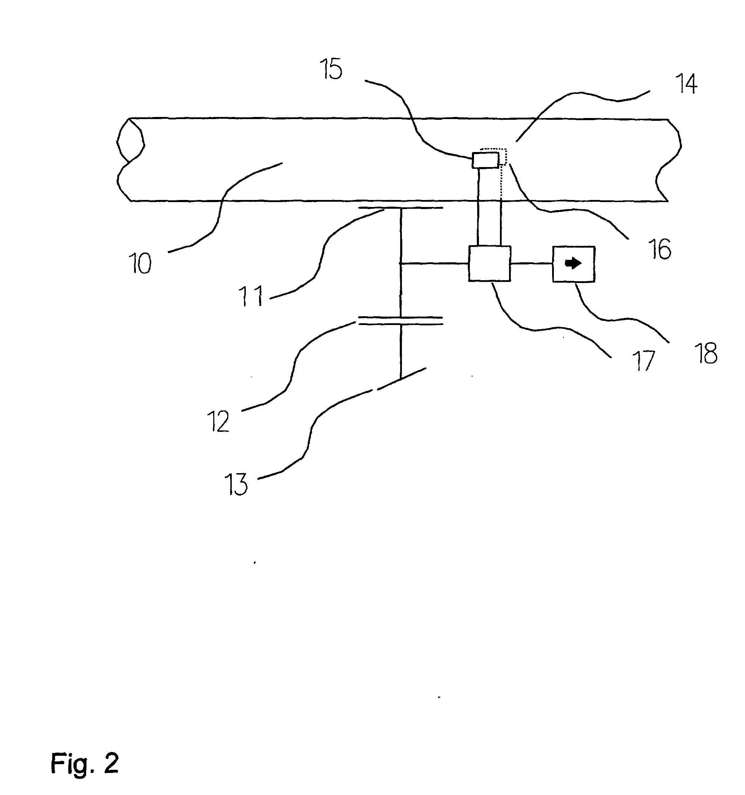

Referring to fig. 2, a directional high voltage detector 5 is displayed together with a conductor 10 in a transmission and distribution system 2. The directional detector comprises a voltage measuring circuit with a capacitive detector 11 and a current measuring circuit with one or more magnetic field detectors 14. The capacitive detector 11 forms a voltage divider together with a capacitor 12. The capacitor 12 is also connected to a reference potential 13 which may be chosen as the symmetrical point of origin of e.g. a 3-phase cable, which equals a ground potential.

The divided measured voltage value and the measured current value are fed to a calculation circuit 17 which calculate a directional value for the energy flow in the conductor on the basis of the values.

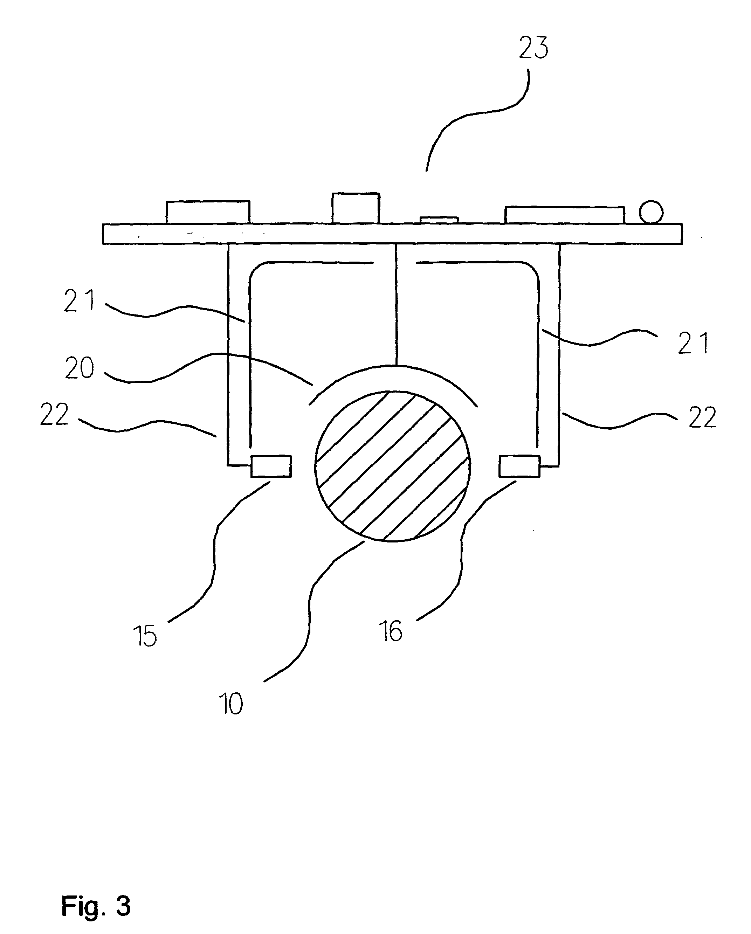

Referring to fig. 3, a preferred embodiment of the directional detector is illustrated. The capacitive measuring of the voltage is carried out through a capacitive coupling between a metal panel 20 and the conductor 10. The metal panel 20 is curved so that it follows the shape of the conductor 10 and is in close proximity ensuring a high capacitance in the capacitive coupling. The metal panel 20 is preferably rectangular with an area between 4 to 6 cm² of metal panel mounted a few millimeters over the conductor 10. Other shapes and area sizes of the metal panel 20 are naturally also possible.

The current measuring circuit comprises one or more magnetic field detectors 14 for detecting the magnetic field generated by the current flow in the conductor 10. The magnetic field detector 14 is preferably a hall element 15, 16 placed in close proximity to the conductor. The hall element provides a voltage proportional to the current in the conductor.

To avoid or minimise interference from external magnetic fields it is preferred to use double hall elements instead of single. This will cancel out interference fields because the first hall element will detect the interference fields in one direction and the second hall element will detect the interference fields in the opposite direction resulting in a measured value of nil. Examples of external magnetic fields are the earth magnetic field and magnetic fields from conductors or components placed close to the detector.

The detected values are led to the calculation circuit 17 placed on a circuit board 23. To avoid any magnetic fields generating voltage in the supply lines 22 for the magnetic field detectors 14 the lines are surrounded by shields 21 connected to a ground potential. The shields 21 also protect the circuit board 23 containing the calculation circuit 17.

The isolation of the entire detector in relation to the high voltage is obtained by embedding the entire circuit in silicone rubber. At the same time, the silicone is used as a dielectric between the metal panel and the conductor. The voltage providing cable and the ground cable from the construction are led through an isolating silicone tube into the silicone protected circuit. Thus, the construction becomes protected from an electrical point of view.

The cables will normally be shielded to avoid any generation of interference magnetic fields in close proximity to the detectors.

The calculation circuit 17 generates information concerning the energy direction either through an optic fibre to e.g. a control center or on a display 18 comprising e.g. a couple of light-emitting diodes (LEDs) indicating an energy flow in one direction or the other.

The voltage often falls out in case of short-circuiting. This is the reason why the calculation circuit 17 simulates the voltage in 1 to 2 seconds subsequent to the detection of a fault on the conductor. In this manner, it is still possible to compare the polarity of the recorded short circuit current with the polarity of the voltage. The direction of the short circuit current is determined by the calculation circuit 17 within the first two periods after a current increase above a certain trigger level.

The energy supply takes place from an external voltage source. This voltage source must provide a DC voltage of 9 to 12 volts in such a manner that the DC-ground is galvanically separated from the ground potential. The circuit also requires voltage in the short circuit situation where the voltage supply from the shortcircuited net cannot be expected. This is why the external voltage supply must feature a back-up battery. With the protected construction of the measuring unit, it is possible to replace the battery (approx. every 10 years) without interrupting the high voltage.

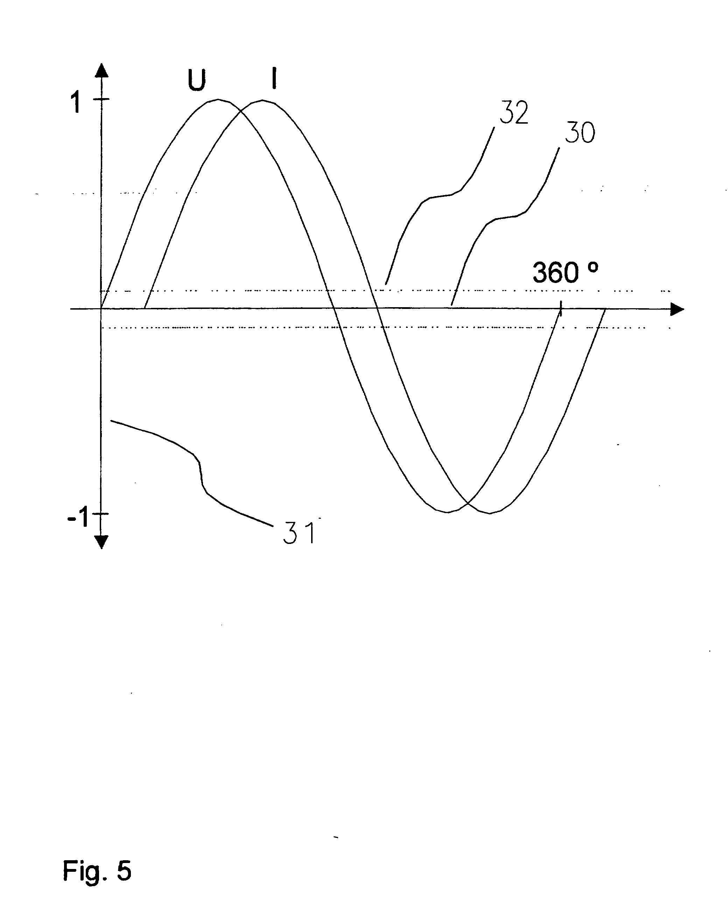

Referring to fig. 5, the calculation circuit samples the signals a number of times per period, presently set at 20 times per period. The exact current I and voltage U, meaning value and polarity, are read at each sampling. During the frequent samplings, it is possible to determine quite accurately when the zero crossing (phase change) of the voltage takes place. Once the voltage polarity has been determined, it is possible to determine the sample numbers of a period certain to provide a comparison of the polarity of the current and the voltage.

In a preferred embodiment of the invention, the relative direction of the energy is determined by a simple mathematical multiplication of the polarity of the current and the voltage at a given point in time between the zero crossings.

The detector will determine the direction of the energy flow when a high current above a certain limit is detected.

The polarity of the current is measured and subsequently compared with the polarity of the voltage (whether actually measured or simulated) and the energy direction is determined. One or more of the zero crossings of the voltage or current can be simulated as well as measured.

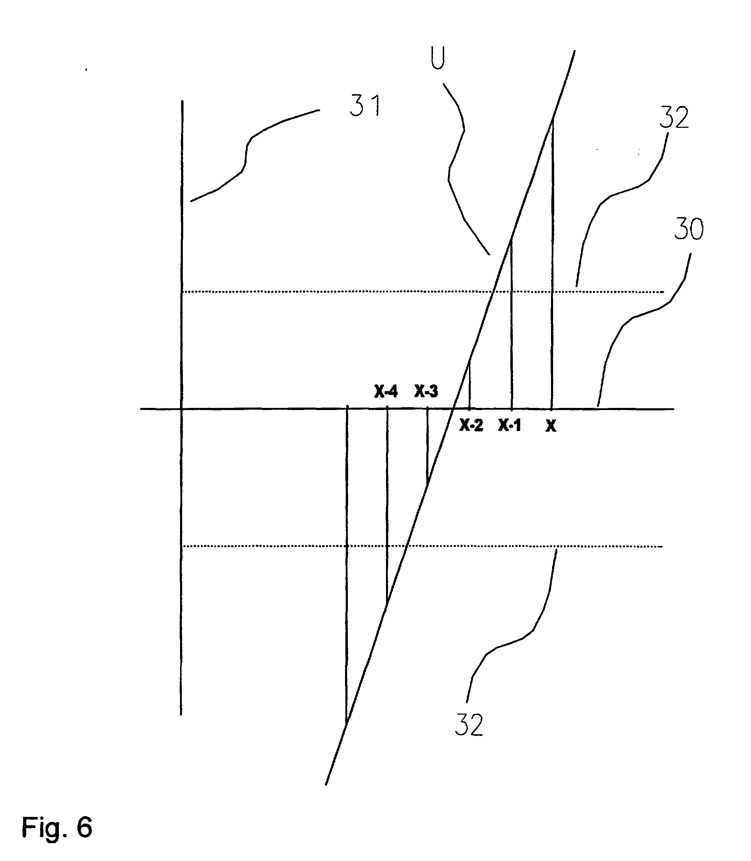

Referring to fig. 6, the algorithm is designed in such a manner that once the voltage is above the positive noise limit, it is checked if a zero crossing has taken place immediately before that. If the preceding voltage (at the preceding sampling) is below a positive noise limit, a closer examination is made. If the voltage is below the negative noise limit 4/20 periods earlier (4 samples ago), a zero crossing has taken place.

The sample number for the exact zero crossing point in time must now be somewhere between the current sample X and the 4/20 previously made sample X-4. If the value of the sample X-3 is below the negative noise limit, the zero crossing is at X-1 or X-2. Of the two samples, the sample closest to zero is chosen irrespective of the noise limit. If the value for X-3 is above the negative noise limit, X-2 is chosen as the zero crossing value.

Despite the above-mentioned algorithm, there is still a minimal risk that the determination of the zero crossing may be incorrect in a noise-filled reading environment. This is the reason why the algorithm has a built-in phase-locked loop circuit so that two succeeding zero crossing points may not deviate more than certain period (e.g. 4/20) from each other in their respective period.

With this algorithm, it is possible to make an accurate determination of the zero crossing point in time irrespective of the noise level in the measuring system.

It is understood that the algorithm is capable of determining the zero crossing at a negative to positive voltage crossing (illustrated in fig. 6) as well as a positive to negative crossing.

Those skilled in the art will appreciate that the present invention is not limited to the detection of energy flow direction in the event of a fault on a high voltage transmission and distribution system. Detection and indication of an energy flow direction in a normal working state is also possible as well as indication of an energy flow direction on other high voltage systems involving an energy flow in a conductor.

Also a directional detector for low voltage systems are possible, such as portable detectors for household cabling, making it possible to trace defects in the cabling coursing higher current than in a normal working state. The current and voltage detectors may preferably be of different types than the ones described above. Especially because of the lower current values magnetic-resistive (magneto-resistive) detectors can with advantageously replace the hall elements. The method of measuring the voltage with a capacitive detector may also advantageously be replaced by methods involving direct contact to the conductor.

### List

- 1.: Generator
- 2.: Transmission or distribution system consisting of underground cables or overhead lines
- 3.: Electric users or loads
- 4.: Directional indicators
- 5.: Directional detectors
- 6.: Electrical fault e.g. short circuit
- 10.: Conductor
- 11.: Capacitive detector
- 12.: Capacitor
- 13.: Reference potential e.g. ground potential
- 14.: Electromagnetic field detector
- 15.: First electromagnetic field detector element
- 16.: Second electromagnetic field detector element
- 17.: Calculating circuit
- 18.: Directional indicator
- 20.: Metal panel
- 21.: Shield for electromagnetic field
- 22.: Supply lines to the electromagnetic field detectors
- 23.: Circuit board containing the calculation circuit
- 30.: X-axis in degrees (°)
- 31.: Y-axis in absolute values (U/U and I/I)
- 32.: Noise level
- U.: Voltage
- I.: Current
- Tr.: Transformer
- Hv.: High voltage cable or line
- X, X-1, ...: Samples of the X-axis

## Claims

1. Directional high-voltage detector (5) for a high-voltage conductor (10) comprising
• at least one voltage-measuring circuit for measuring voltage on said conductor (10) by means of at least one capacitive detector (11),
• at least one current-measuring circuit for measuring current in said conductor (10) by means of at least one magnetic field detector (14, 15, 16),
• and means for deriving the energy flow in the conductor (10) on the basis of measurements made by said voltage-measuring circuit and said current-measuring circuit,
**characterised in that**
said means determine the energy flow direction on the basis of the respective polarity of the current and voltage at a given point in time between two successive zero-crossings of the voltage.

2. Directional high-voltage detector according to claim 1, **characterised in that** the at least one capacitive detector (11) forms a capacitive coupling with the conductor (10).

3. Directional high-voltage detector according to claim 2, **characterised in that** the capacitive detector (11) comprises a metal plate (20) covering a section of the conductor (10) partially or totally.

4. Directional high-voltage detector according to claim 3, **characterised in that** the edges or corners of the plate are bent away from the conductor (10).

5. Directional high-voltage detector according to claim 3, **characterised in that** the dielectric material between the metal plate (20) and the conductor (10) is silicone covering the surface of said detector partially or totally.

6. Directional high-voltage detector according to claim 5, **characterised in that** the silicone serves as an isolation layer between the high-voltage potentials in said detector and the exterior, respectively.

7. Directional high-voltage detector according to claim 2, **characterised in that** at least one capacitor (12) is connected serially to the capacitive coupling and a reference potential (13), respectively.

8. Directional high-voltage detector according to claim 7, **characterised in that** the reference potential (13) is the ground potential of the conductor (10).

9. Directional high-voltage detector according to claim 1, **characterised in that** the magnetic field detector (14) comprises two hall elements (15, 16).

10. Directional high-voltage detector according to claim 1, characterised i n that the supply lines for the magnetic field detector (14) and the calculation circuit (17) comprise shields (21) against magnetic fields.

11. Directional high-voltage detector according to claim 1, **characterised in that** the magnetic field detector (14) comprises at least one magnetoresistive detector.

12. Method of determining the direction of the energy flow in a high-voltage conductor wherein at least one voltage-measuring circuit measures voltage on said conductor by means of at least one capacitive detector, at least one current-measuring circuit measures current in said conductor by means of a magnetic field detector and a calculation circuit calculating a directional value derived from the measured voltage and current on the basis of the respective polarity of the current and the voltage at a given point in time between two successive zero-crossings of the voltage.

13. Method of determining the direction of the energy flow in a high-voltage conductor according to claim 12, **characterised in that** the calculation circuit calculates the directional value on the basis of the respective polarity the current and the voltage at a given point in time between two preceding successive zero-crossings of the voltage.

14. Method of determining the direction of the energy flow in a high-voltage conductor according to claim 12, **characterised in that** the calculation circuit divides said voltage into a number of samples within a period of time and where said calculation circuit compares the first voltage sample value numerically larger than a constant value with the immediately preceding values to determine the sample value closest to zero voltage.

15. Method of determining the direction of the energy flow in a high-voltage conductor according to claim 14, **characterised in that** the calculation circuit calculates the directional value on the basis of the respective polarity of the current and voltage at a given point in time between two preceding successive zero-crossings of the voltage.

16. Method of determining the direction of the energy flow in a high-voltage conductor according to claim 15, **characterised in that** the constant value exceeds the noise level.

## Patentansprüche

1. Richt-Hochspannungsdetektor (5) für einen Hochspannungsleiter (10) umfassend
• wenigstens eine Spannungsmeßschaltung zum Messen der Spannung an dem Leiter (10) mittels wenigstens eines kapazitiven Detektors (11),
• wenigstens eine Strommeßschaltung zum Messen des Stromes in dem Leiter (10) mittels wenigstens eines Magnetfelddetektors (14, 15, 16),
• sowie Mittel zum Ableiten des Energiestroms in dem Leiter (10) auf Basis von Messungen, die mittels der Spannungsmeßschaltung und der Strommeßschaltung vorgenommen sind,
**dadurch gekennzeichnet, daß**
die Mittel die Energiestromrichtung auf der Basis der jeweiligen Polarität des Stroms und der Spannung zu einem gegebenen Zeitpunkt zwischen zwei aufeinanderfolgenden Null-Durchgängen der Spannung bestimmen.

2. Richt-Hochspannungsdetektor nach Anspruch 1, **dadurch gekennzeichnet, daß** der wenigstens eine kapazitive Detektor (11) eine kapazitive Kupplung mit dem Leiter (10) bildet.

3. Richt-Hochspannungsdetektor nach Anspruch 2, **dadurch gekennzeichnet, daß** der kapazititve Detektor (11) eine Metallplatte (20) umfaßt, die einen Abschnitt des Leiters (10) teilweise oder gänzlich bedeckt.

4. Richt-Hochspannungsdetektor nach Anspruch 3, **dadurch gekennzeichnet, daß** die Ränder oder Ecken der Platte von dem Leiter (10) weg gebogen sind.

5. Richt-Hochspannungsdetektor nach Anspruch 3, **dadurch gekennzeichnet, daß** das dielektrische Material zwischen der Metallplatte (20) und dem Leiter (10) Silizium ist, das die Oberfläche des Detektors teilweise oder ganz bedeckt.

6. Richt-Hochspannungsdetektor nach Anspruch 5, **dadurch gekennzeichnet, daß** das Silizium als Isolationslage zwischen den Hochspannungspotentialen in dem Detektor bzw. dem Äußeren dient.

7. Richt-Hochspannungsdetektor nach Anspruch 2, **dadurch gekennzeichnet, daß** wenigstens ein Kondensator (12) seriell mit der kapazitiven Kupplung bzw. einem Bezugspotential (13) verbunden ist.

8. Richt-Hochspannungsdetektor nach Anspruch 7, **dadurch gekennzeichnet, daß** das Bezugspotential (13) das Erdpotential des Leiters (10) ist.

9. Richt-Hochspannungsdetektor nach Anspruch 1, **dadurch gekennzeichnet, daß** der Magnetfelddetektor (14) zwei Hall-Elemente (15, 16) umfaßt.

10. Richt-Hochspannungsdetektor nach Anspruch 1, **dadurch gekennzeichnet, daß** die Versorgungsleitungen für den Magnetfelddetektor (14) und die Berechnungsschaltung (17) Schilde (21) gegen Magnetfelder umfassen.

11. Richt-Hochspannungsdetektor nach Anspruch 1, **dadurch gekennzeichnet, daß** der Magnetfelddetektor (14) wenigstens einen magneto-resistiven Detektor umfaßt.

12. Verfahren zum Bestimmen der Richtung des Energiestroms in einem Hochspannungsleiter, wobei wenigstens eine Spannungsmeßschaltung die Spannung an dem Leiter mittels wenigstens eines kapazitiven Detektors mißt, wenigstens eine Strommeßschaltung den Strom in dem Leiter mittels eines Magnetfelddetektors mißt und eine Berechnungsschaltung den Richtwert, abgeleitet aus gemessener Spannung und Strom, auf der Basis der jeweiligen Polarität des Stroms und der Spannung zu einem bestimmten Zeitpunkt zwischen zwei aufeinanderfolgenden Null-Durchgängen der Spannung berechnet.

13. Verfahren zum Bestimmen der Richtung des Energiestroms in einem Hochspannungsleiter nach Anspruch 12, **dadurch gekennzeichnet, daß** die Berechnungsschaltung den Richtwert auf der Basis der jeweiligen Polarität des Stroms und der Spannung zu einem gegebenen Zeitpunkt zwischen zwei vorhergehenden aufeinanderfolgenden Null-Durchgängen der Spannung berechnet.

14. Verfahren zum Bestimmen der Richtung des Energiestroms in einem Hochspannungsleiter nach Anspruch 12, **dadurch gekennzeichnet, daß** die Berechnungsschaltung die Spannung in eine Anzahl Abtastwerte innerhalb eines Zeitraumes teilt und wobei die Berechnungsschaltung den ersten Spannungsabtastwert, der numerisch größer als ein konstanter Wert ist, mit den unmittelbar vorhergehenden Werten vergleicht, um den der Nullspannung nahesten Abtastwert zu bestimmen.

15. Verfahren zum Bestimmen der Richtung des Energiestroms in einem Hochspannungsleiter gemäß Anspruch 14, **dadurch gekennzeichnet, daß** die Berechnungsschaltung den Richtwert auf der Basis der jeweiligen Polarität des Stroms und der Spannung zu einem gegebenen Zeitpunkt zwischen zwei vorhergehenden aufeinanderfolgenden Null-Durchgängen der Spannung berechnet.

16. Verfahren zum Bestimmen der Richtung des Energiestroms in einem Hochspannungsleiter nach Anspruch 15, **dadurch gekennzeichnet, daß** der konstante Wert den Geräuschpegel übersteigt.

## Revendications

1. Détecteur de haute tension directionnel (5) pour un conducteur haute tension (10) comprenant :
- au moins un circuit de mesure de tension pour mesurer la tension sur ledit conducteur (10) au moyen d'au moins un détecteur capacitif (11),
- au moins un circuit de mesure de courant pour mesurer le courant dans ledit conducteur (10) au moyen d'au moins un détecteur de champ magnétique (14,15,16),
- et des moyens pour dériver le flux d'énergie dans le conducteur (10) sur la base de mesures effectuées par ledit circuit de mesure de tension et ledit circuit de mesure de courant,
**caractérisé en ce que** lesdits moyens déterminent la direction du flux d'énergie sur la base de la polarité respective du courant et de la tension à un point donné dans le temps entre deux passages par zéro successifs de la tension.

2. Détecteur haute tension directionnel selon la revendication 1, **caractérisé en ce que** au moins un détecteur capacitif (11) forme un couplage capacitif avec le conducteur (10).

3. Détecteur haute tension directionnel selon la revendication 2, **caractérisé en ce que** le détecteur capacitif (11) comprend une plaque métallique (20) recouvrant une section du conducteur (10) partiellement ou totalement.

4. Détecteur haute tension directionnel selon la revendication 3, **caractérisé en ce que** les bords ou coins de la plaque sont pliés dans une direction s'éloignant du conducteur (10).

5. Détecteur haute tension directionnel selon la revendication 3, **caractérisé en ce que** le matériau diélectrique entre la plaque métallique (20) et le conducteur (10) est en silicone recouvrant la surface dudit détecteur partiellement ou totalement.

6. Détecteur haute tension directionnel selon la revendication 5, **caractérisé en ce que** la silicone sert de couche d'isolation entre les potentiels haute tension dans ledit détecteur et l'extérieur respectivement.

7. Détecteur haute tension directionnel selon la revendication 2, **caractérisé en ce que** au moins un condensateur (12) est connecté en série sur le couplage capacitif et un potentiel de référence (13) respectivement.

8. Détecteur haute tension directionnel selon la revendication 7, **caractérisé en ce que** le potentiel de référence (13) est le potentiel de masse du conducteur (10).

9. Détecteur haute tension directionnel selon la revendication 1, **caractérisé en ce que** le détecteur de champ magnétique (14) comprend deux éléments à effet Hall (15,16).

10. Détecteur haute tension directionnel selon la revendication 1, **caractérisé en ce que** les lignes d'alimentation pour le détecteur de champ magnétique (14) et le circuit de calcul (17) comprennent des blindages (21) contre les champs magnétiques.

11. Détecteur haute tension directionnel selon la revendication 1, **caractérisé en ce que** le détecteur de champ magnétique (14) comprend au moins un détecteur magnéto - résistif.

12. Procédé pour déterminer la direction du flux d'énergie dans un conducteur haute tension, dans lequel au moins un circuit de mesure de tension mesure la tension sur ledit conducteur, au moins un circuit de mesure de courant mesure le courant dans ledit conducteur au moyen d'un détecteur de champ magnétique et un circuit de calcul calculant une valeur directionnelle dérivée de la tension et du courant mesurés sur la base de la polarité respective du courant et de la tension à un point donné dans le temps entre deux passages par zéro successifs de la tension.

13. Procédé pour déterminer la direction du flux d'énergie dans un conducteur haute tension selon la revendication 12, **caractérisé en ce que** le circuit de calcul calcule la valeur directionnelle sur la base de la polarité respective du courant et de la tension à un point donné dans le temps entre deux passages par zéro successifs de la tension.

14. Procédé pour déterminer la direction du flux d'énergie dans un conducteur haute tension selon la revendication 12, **caractérisé en ce que** le circuit de calcul divise ladite tension en un nombre d'échantillons à l'intérieur d'une période de temps et où ledit circuit de calcul compare la première valeur d'échantillon de tension numériquement plus grande qu'une valeur constante avec les valeurs immédiatement précédentes pour déterminer la valeur d'échantillon la plus proche de la tension zéro.

15. Procédé pour déterminer la direction du flux d'énergie dans un conducteur de tension selon la revendication 14, **caractérisé en ce que** le circuit de calcul calcule la valeur directionnelle sur la base de la polarité respective du courant et de la tension à un point donné dans le temps entre deux passages par zéro successifs précédents de la tension.

16. Procédé pour déterminer la direction du flux d'énergie dans un conducteur haute tension selon la revendication 15, **caractérise en ce que** la valeur constance dépasse le niveau sonore.
